## Europäisches Patentamt
## European Patent Office
## Office européen des brevets

(19)

(11) Veröffentlichungsnummer: **0 187 198 B1**

# EUROPÄISCHE PATENTSCHRIFT

(12)

(45) Veröffentlichungstag der Patentschrift: **03.06.92**

(21) Anmeldenummer: **85111386.0**

(22) Anmeldetag: **09.09.85**

(51) Int. Cl.5: **G02B 6/12**, G02B 6/42, H01L 31/02, H01L 33/00

(54) **Verfahren zur Herstellung einer integriert - optischen Anordnung.**

(30) Priorität: **07.01.85 DE 3500327**

(43) Veröffentlichungstag der Anmeldung:
**16.07.86 Patentblatt 86/29**

(45) Bekanntmachung des Hinweises auf die
Patenterteilung:
**03.06.92 Patentblatt 92/23**

(84) Benannte Vertragsstaaten:
**AT BE CH DE FR GB IT LI LU NL SE**

(56) Entgegenhaltungen:
**EP-A- 0 080 945**
**US-A- 4 136 928**

**IEEE TRANSACTIONS ON ELECTRON DEVI-CES, Band ED-29, Nr. 9, September 1982, Seiten 1372-1381, IEEE, New York, US; N. BAR-CHAIM et al.: "GaAs integrated optoe-lectronics"**

**IEEE JOURNAL OF OUANTUM ELECTRONICS, Band OE-13, Nr. 4, April 1977, Seiten 220-223; K. AIKI et al.: "A frequency-multiplexing light source with monolithically integrated distributed-feedback diode lasers"**

**TECHNICAL DIGEST, Nr. 64, Oktober 1981, Seite 39, Western Electric; R.C. MILLER: "Optical transceiver"**

(73) Patentinhaber: **SIEMENS AKTIENGESELL-SCHAFT**
**Wittelsbacherplatz 2**
**W-8000 München 2(DE)**

(72) Erfinder: **Plihal, Manfred, Dr.**
**Sonnenspitzstrasse 13**
**W-8000 München 82(DE)**
Erfinder: **Schlötterer, Heinrich, Dr.**
**Andreas-Wagner-Strasse 11a**
**W-8011 Putzbrunn(DE)**
Erfinder: **Trommer, Reiner, Dr.**
**Scherbaumstrasse 9b**
**W-8000 München 83(DE)**

EP 0 187 198 B1

## Beschreibung

Die Erfindung betrifft ein Verfahren zur Herstellung einer insbesondere für die bidirektionale optische Nachrichten-Übertragung dienenden Anordnung nach dem Oberbegriff des Patentanspruchs 1.

Aus der US-A-4 136 928 ist ein Verfahren zur Herstellung einer integriert optischen Anordnung aus einer Laserdiode, einem Streifen- oder Schichtwellenleiter und einem Photodetektor auf einem gemeinsamen Substrat bekannt, wobei in einem Epitaxieschritt ein Schichtenstapel auf dem Substrat erzeugt wird, der aus vier Schichten besteht und der eine laseraktive Schicht und eine darunterliegende, eine wellenleitende Schicht des Streifenwellenleiters bildende tieferliegende Schicht aufweist, deren Brechzahl größer als die des von unten her angrenzenden Mediums und kleiner als die der laseraktiven Schicht ist. Die beiden oberen Schichten des Schichtenstapels werden außerhalb des für die Laserdiode vorgesehenen Bereichs und eines für den Photodetektor vorgesehenen Bereichs selektiv entfernt, so daß die Schichten für die Laserdiode und den Photodetektor als Mesas auf den beiden unteren Schichten des Schichtenstapels stehenbleiben.

Aus IEEE Journal of Quantum Electron., Vol. QE-13, No. 4, April 1977, geht hervor, wie eine Kopplung einer DFB-Laserdiode an einen passiven Streifenwellenleiter auf einem gemeinsamen Substrat hergestellt werden kann. Bei diesem Herstellungsverfahren wird in einem ersten Epitaxieschritt ein aus drei Schichten bestehender Schichtenstapel für die Laserdiode hergestellt, in dessen Oberfläche ein Gitter geätzt wird. Außerhalb des Bereichs der Laserdiode wird dieser Schichtenstapel bis zum Substrat abgeätzt, so daß die Laserdiode als Mesa auf dem Substrat stehenbleibt. In einem zweiten Epitaxieschritt werden der Mesa und das freiliegende Substrat mit einem aus zwei Schichten bestehenden Schichtenstapel überwachsen, die im Bereich außerhalb der Laserdiode den Streifenwellenleiter bildet, wobei eine in Höhe einer laseraktiven Schicht der Laserdiode liegende Schicht des Streifenwellenleiters eine wellenleitende Schicht dieses Wellenleiters bildet, in welchem das von der Laserdiode abgegebene Licht geführt wird.

Für die bidirektionale optische Nachrichtenübertragung über beispielsweise eine Glasfaser, wobei für die beiden Übertragungsrichtungen elektromagnetische Strahlung mit verschiedenen Wellenlängen $\lambda_1$ bzw. $\lambda_2$ eingesetzt werden, werden an den Streckenenden je ein Sende- und Empfangselement sowie ein passives optisches Bauelement in Form eines wellenlängenselektierenden Bauelements benötigt, d.h. eine Anordnung der eingangs genannten Art. Eine derartige Anordnung wird derzeit noch in Hybridform aufgebaut, was sehr arbeits- und kostenintensiv ist, so daß diese Hybridaufbauten für die sogenannten Teilnehmeranschlüsse zu aufwendig sind, wobei die Größe, Stabilität, Kosten usw. für den Aufwand bestimmend sind.

Zur integrierten Herstellung einer Anordnung der eingangs genannten Art, insbesondere einer Multiplex-Demultiplex-Anordnung für bidirektionale optische Nachrichtenübertragung müssen mindestens eine Laserdiode, ein Fotodetektor, beispielsweise eine Fotodetektordiode, sowie passive Wellenleiter und passive optische Bauelemente, insbesondere wellenlängenselektierende Bauelemente, auf einem Substrat, d.h. monolithisch, aufgebaut werden. Dies wirft beträchtliche Probleme dadurch auf, daß erheblich voneinander abweichende Schichtaufbauten und Schichteigenschaften, beispielsweise der Schichtaufbau und die Schichteigenschaften einer Laserdiode und der bzw. die einer Detektordiode aufeinandertreffen.

Beispielsweise zeigt ein aus der älteren deutschen Patentanmeldung P 34 36 306.8 hervorgehender Vorschlag bereits, wie eine DFB-Laserdiode mit einem Streifenwellenleiter integriert werden kann. Dabei ist die Verwendung von InGaAsP-Schichten, also Q-Schichten, wesentlich. Für Fotodioden kommen in erster Linie ternäre Schichten aus InGaAs in Frage. Darin ist ein wesentlicher Grund zu sehen, daß die Vereinigung solcher Elemente auf einem gemeinsamen Substrat zu erheblichen Problemen führt, denn die mit quarternären Schichten und die mit ternären Schichten aufgebauten Schichtstapel sind in den Schichtfolgen verschieden und nicht aufeinander abgestimmt.

Aufgabe der vorliegenden Erfindung ist es, ein kostengünstiges Verfahren zur Herstellung einer stabilen und einfach in großen Stückzahlen herstellbaren Anordnung der eingangs genannten Art bereitzustellen.

Diese Aufgabe wird durch die im Patentanspruch 1 angegebenen Merkmale gelöst.

Ein besonderer Vorteil der Erfindung liegt darin, daß die Anordnung mit nur zwei Epitaxieschritten herstellbar ist. Das erfindungsgemäße Verfahren unterscheidet sich von dem in der bereits genannten älteren Patentanmeldung angegebenen Verfahren zur Herstellung einer an einen Wellenleiter gekoppelten Laserdiode nur dadurch, daß im zweiten Epitaxieschritt lediglich eine oder mehrere zusätzliche Schichten aufgebracht werden, in dem eine bestimmte Dotierung ausgebildet oder auszubilden ist. Die oberste der drei Schichten ist zur Ausbildung des Fotodetektors vorgesehen und kann eine undotierte Schicht sein, in der entsprechend Anspruch 2 die notwendige Dotierung durch Diffusion erzeugt wird. Sie kann aber auch entsprechend Anspruch 3 aus einer Doppelschicht bestehen, bei der eine Schicht undotiert ist und die andere der Diffusionsdotierung entsprechend dotiert ist. Diese Doppelschicht kann in dem zweiten Epitaxieschritt erzeugt werden und eine Diffusion ist dann überflüssig.

Wenn neben dem Streifen- oder Schichtwellenleiter weitere passive optische Bauelemente durch Strukturgebung des Schichtwellenleiters zu erzeugen sind, so wird bei dem erfindungsgemäßen Verfahren zweckmäßigerweise gemäß Anspruch 4 so vorgegangen, daß vor dem zweiten Epitaxieschritt und nach dem bereichsweisen Abtragen des beim ersten Epitaxieschritt erzeugten Schichtenstapels bis zur tieferliegenden Schicht diese Schicht zur Bildung des passiven optischen Bauelements strukturiert wird.

Zur Herstellung eines Fotodetektors wird bei dem erfindungsgemäßen Verfahren zweckmäßigerweise nach Anspruch 5 so vorgegangen, daß die oberste Schicht der beim zweiten Epitaxieschritt aufgebrachten drei Schichten gegebenenfalls zusammen mit darüberliegenden Schichten außerhalb des für den Fotodetektor vorgesehenen Bereichs entfernt wird.

Ein Beispiel für eine erfindungsgemäße Anordnung ist der bereits erwähnte monolithisch integrierte Multiplex-Demultiplex-Baustein. Andere Beispiele für eine erfindungsgemäße Anordnung sind ein monolithischer Heterodyn- oder Homodyn-Empfänger, bei denen ebenfalls Laser- und Fotodioden miteinander und mit anderen optischen Bauelementen integriert werden müssen, und die ebenfalls für die optische Nachrichtentechnik vorgesehen sind.

Die Erfindung wird am Beispiel eines monolithisch integrierten Multiplex-Demultiplex-Bausteins mit DFB-Laserdiode und Fotodiode anhand der Figuren näher erläutert. Von den Figuren zeigen:

Figur 1     einen in Strahlungsausbreitungsrichtung geführten Längsschnitt durch einen monolithisch integrierten Multiplex-Demultiplex-Baustein,

Figur 2     einen Ausschnitt aus einer der Figur 1 entsprechenden Schnittansicht durch eine leicht modifizierte Anordnung, bei welcher die Kontakte zum Betrieb des Fotodetektors auf einer Seite des Substrats angeordnet sind,

Figur 3     einen Ausschnitt aus einer der Figur 1 entsprechenden Schnittansicht durch eine andere modifizierte Ausführungsform einer Anordnung, bei welcher der dotierte Bereich in der obersten der beim zweiten Epitaxieschritt aufgebrachten drei Schichten durch Diffusion erzeugt ist,

Figur 4     einen Ausschnitt aus einer der Figur 1 entsprechenden Schnittansicht durch eine Ausführungsform einer Anordnung, bei welcher der Streifen- oder Schichtwellenleiter durch Stirnflächenkopplung an den Fotodetektor gekoppelt ist,

Figur 5     in Draufsicht auf einen Multiplex-Demultiplex-Baustein nach einer der Figuren 1 bis 4 schematisch eine erste Anordnung seiner Bauelemente, wobei die Schnittdarstellungen nach den Figuren 1 bis 4 sich aus einem längs der Schnittlinie V - V in Figur 5 geführten Schnitt senkrecht zur Zeichenebene und durch Zurückklappen der dabei entstehenden und im 90°-Winkel zueinander angeordneten Schnittflächen in eine Ebene entstanden sind, und

Figur 6     in Draufsicht auf einen ähnlichen Multiplex-Demultiplex-Baustein schematisch eine Anordnung seiner Bauelemente.

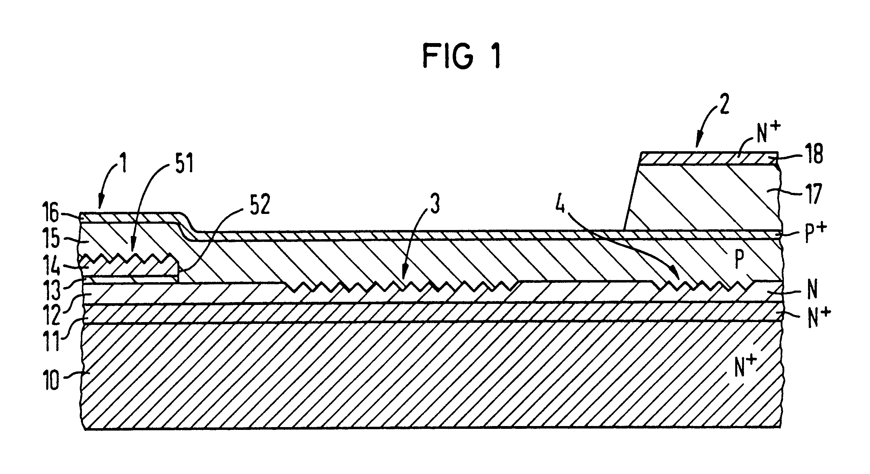

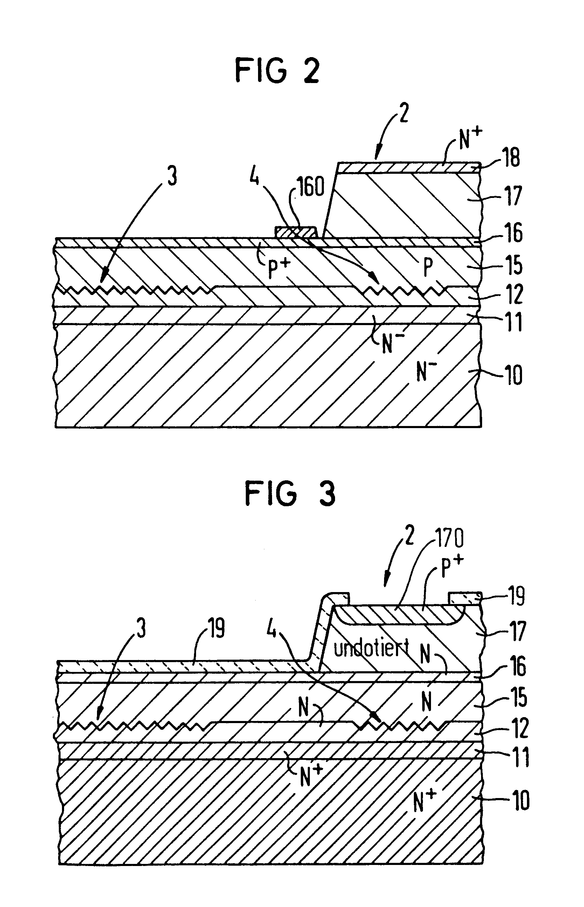

Bei dem Multiplex-Demultiplex-Baustein nach Figur 1 sind die DFB-Laserdiode 1 mit dem angekoppelten Streifen- oder Schichtwellenleiter 12 durch die auf das Substrat 10 aufgebrachten Schichten 11 bis 16 gegeben. Der Aufbau entspricht im wesentlichen dem in der genannten älteren Patentanmeldung P 34 36 306.8 und unterscheidet sich davon lediglich durch das wellenlängenselektierende Gitter 3 und das Ablenkgitter 4, die beide in die dem Streifen- oder Schichtwellenleiter bildende Schicht 12 eingebracht sind. Ansonsten entspricht die Schichtfolge aus den Schichten 11 bis 16 der Figur 1 der Schichtfolge 1, 2 und 4 bis 7 in Figur 3 der genannten älteren Patentanmeldung. Dort ist zwischen den Schichten 2 und 4, die in der vorliegenden Figur 1 den beiden Schichten 12 und 13 entsprechen, noch eine dünne Ätzstoppschicht 3 eingezeichnet, die auch bei dem vorliegenden Baustein nach Figur 1 zweckmäßigerweise verwendet wird. Es sei im folgenden angenommen, daß eine solche Ätzstoppschicht, wenn sie vorhanden ist, Bestandteil der Schicht 12 ist.

Bei dem Baustein nach Figur 1 besteht das Substrat 10 aus InP mit einer $N^+$-Dotierung von beispielsweise $10^{17}$-$10^{18}$. Die Schicht 11 besteht aus dem gleichen Material und weist beispielsweise eine Dicke von 0,5 $\mu$m auf. Die Schicht 12 besteht aus einer Q-Schicht, was Schicht aus quaternärem Material bedeutet. Quaternäres Material ist beispielsweise InGaAsP oder InGaAlAs. Bei dem beispielhaften Baustein nach Figur 1 bestehen Q-Schichten durchwegs aus InGaAsP.

Die Schicht 12 weist eine N-Dotierung von höchstens $10^{17}$, eine Dicke zwischen 0,3 und 0,5 $\mu$m und einen einer Fluoreszenzwellenlänge von etwa 1,3 $\mu$m entsprechenden Bandabstand auf.

Eine auf die Schicht 12 aufgebrachte Ätzstoppschicht kann beispielsweise aus InP bestehen. Eine solche Ätzstoppschicht kann beispielsweise eine Dicke von 0,1 $\mu$m und eine N-Dotierung von $10^{17}$ aufweisen.

Die laseraktive Schicht 13 besteht aus einer undotierten oder eigenleitenden Q-Schicht mit beispielsweise einer Schichtdicke von 0,2 $\mu$m und einem einer Fluoreszenzwellenlänge von 1,55 $\mu$m entsprechenden Bandabstand.

Die Schicht 14, in der das Gitter 51 der DFB-Laserdiode ausgebildet ist, besteht aus einer P-dotierten Q-Schicht mit beispielsweise einer Schichtdicke von 0,3 $\mu$m und einem einer Fluoreszenzwellenlänge von 1,3 $\mu$m entsprechenden Bandabstand.

Die Schicht 15 besteht aus einer InP-Schicht, die beispielswiese eine P-Dotierung von $10^{17}$ und eine Schichtdicke von 1 - 1,5 $\mu$m aufweist. Die Schicht 16 besteht aus einer Q-Schicht mit einer $P^+$-Dotierung von beispielsweise $10^{18}$, einer Schichtdicke von beispielsweise 0,2 $\mu$m und beispielsweise einem einer Fluoreszenzwellenlänge von 1,2 $\mu$m entsprechenden Bandabstand. Anstelle der P-Dotierung könnten die beiden Schichten 15 und 16 ebenso gut eine N-Dotierung von beispielsweise $10^{17}$ aufweisen.

Bis hierher entspricht, wie schon erwähnt, der Baustein nach Figur 1 im wesentlichen der DFB-Laserdiode mit angekoppeltem Streifen- oder Schichtwellenleiter nach Figur 3 der genannten älteren Patentanmeldung. Die DFB-Laserdiode 1 ist in der vorliegenden Figur 1 durch den Abschnitt links von der Stufe 52 realisiert.

Bei dem Baustein nach Figur 1 sind zusätzlich noch das wellenlängenselektierende Gitter 3 und ein Fotodetektor 2 in Form einer Fotodiode mit darunterliegendem Ablenkgitter 4 vorhanden.

Die Fotodiode ist durch eine auf die Schicht 16 unmittelbar aufgebrachte undotierte Schicht 17 aus ternärem Material, beispielsweise InGaAs und eine darauf aufgebrachte Schicht 18 aus ternärem Material, ebenfalls beispielsweise aus InGaAs, realisiert, die eine zur Dotierung der Schicht 16 entgegengesetzte Dotierung, im Beispiel nach Figur 1 also eine N-Dotierung, aufweist. Die Schicht 17 weist beispielsweise eine Schichtdicke von 3 $\mu$m auf. Die Schicht 18 hat eine $N^+$-Dotierung von beispielsweise $10^{18}$ und eine Schichtdicke von beispielsweise 0,2 $\mu$m. Entsprechend hoch könnte eine $P^+$-Dotierung der Schicht 18 anstelle der $N^+$-Dotierung gewählt werden.

Damit im Streifen- oder Schichtwellenleiter geführte Strahlung in die Fotodiode 2 gelangen kann, ist unter dieser in der Schicht 12 das Ablenkgitter 4 ausgebildet, das zumindest einen Teil der geführten Strahlung zur Fotodiode 2 umlenkt.

Zwischen der Laserdiode 1 und der Fotodiode 2 ist das den eigentlichen Demultiplexer bildende wellenlängenselektierende Gitter 3 in der Schicht 12 ausgebildet. Die parallelen Furchen dieses Gitters 3 verlaufen in einer zur Schicht 12 parallelen und zur Zeichenebene der Figur 1 vertikalen Ebene schräg zu dieser Zeichenebene. Dieses Gitter 3 bildet den eigentlichen Multiplexer und Demultiplexer des Bausteins.

Bei dem Baustein nach Figur 1 sind Kontakte, die zum Betrieb der Laserdiode 1 und des Fotodetektors erforderlich sind, im Bereich der Laserdiode 1 auf die Schicht 16 und im Bereich der Fotodiode 2 auf die Schicht 18 aufzubringen und außerdem ist zumindest ein Kontakt auf das Substrat 10 aufzubringen.

Bevor auf die Herstellung des Bausteins nach Figur 1 näher eingegangen wird, sei kurz seine Wirkungsweise erläutert. Die von der Laserdiode 1 erzeugte elektromagnetische Strahlung mit einer Wellenlänge $\lambda_1$ wird teilweise als Leckwelle in den unter der laseraktiven Schicht 13 befindlichen Streifen- oder Schichtwellenleiter 12 eingekoppelt und gelangt in diesem Wellenleiter über das wellenlängenselektierende Gitter 3, das verhindert, daß diese Strahlung zum integrierten Fotodetektor 2 kommt, zum Ende des Bausteins, um von dort in eine Glasfaser gekoppelt zu werden. Die von der anderen Übertragungsrichtung kommende elektromagnetische Strahlung der Wellenlänge $\lambda_2$ wird aus der Glasfaser in den Streifen- oder Schichtwellenleiter 12 eingekoppelt und gelangt über das wellenlängenselektierende Gitter 3, das jetzt verhindert, daß diese Strahlung der Wellenlänge $\lambda_2$ zur Laserdiode 1 kommt, zum Fotodetektor 2.

Die wesentlichen Prozeßschritte zur Herstellung des Bausteins nach Figur 1 sind folgende:
Zunächst werden in einem ersten Epitaxieschritt ganzflächig die Schichten 11 bis 14 auf dem Substrat lo erzeugt. Danach werden die Schichten 13 und 14 außerhalb des Bereichs der Laserdiode 1 selektiv entfernt, so daß die Stufe 52 entsteht. Dann werden auf der so entstandenen gestuften Oberfläche die verschiedenen Gitter 51, 3 und 4 erzeugt. Dazu werden die verschiedenen Gitterstrukturen in einem oder mehreren Schritten durch Laserlicht oder mit Elektronenstrahlen an den Stellen, an denen die Gitter entstehen sollen, belichtet, und dann die Gitterstrukturen in die Schichten 12 und 14 geätzt. Dies kann durch gemeinsames Ätzen erfolgen. In einem zweiten Epitaxieschritt wird die gestufte Oberfläche mit den eingeätzten Gitterstrukturen mit den Schichten 15 bis 18 überwachsen. Danach werden die Schichten 17 und 18 außerhalb des Bereichs des Fotodetektors 2 selektiv entfernt. Schließlich werden die zum Betrieb der Laserdiode 1 und des Fotodetektors 2 erforderlichen Metallkontakte aufgebracht. Danach unterscheidet sich das vorliegende Herstellungsverfahren von dem in der genannten älteren Patentanmeldung vorgeschlagenen Verfahren im wesentlichen nur dadurch, daß nach dem selektiven Entfernen der Schichten 13 und 14 und vor dem zweiten Epitaxieschritt die Schicht 12 strukturiert wird und daß beim zweiten Epitaxieschritt anstelle von zwei Schichten drei oder mehrere Schichten erzeugt werden, wobei die zusätzlich erzeugten Schichten selektiv entfernt werden. Ein weniger wichtiger Unterschied ist noch darin zu sehen, daß die Gitterstruktur in der Schicht 14 bei dem in der älteren Patentanmeldung vorgeschlagenen Verfahren vor der selektiven Entfernung der Schichten 13 und 14 ganzflächig in der Schicht 14 erzeugt wird. So könnte auch bei dem hier beschriebenen Verfahren vorgegangen werden. Nach dem selektiven Entfernen der Schichten 13 und 14 müßte dann nur noch die Schicht 12 strukturiert werden.

In der Figur 2 ist eine Modifikation des Bausteins nach Figur 1 dargestellt, wobei nur die Hälfte rechts neben dem Gitter 3 gezeigt ist. Bei dieser Modifikation ist das Substrat 10 semiisolierend. Deshalb muß für den Betrieb des Fotodetektors 2 nicht nur die Schicht 18, sondern daneben auch die Schicht 16 mit einem Kontakt versehen werden, der durch Position 160 schematisch angedeutet ist und die Schicht 12 muß von der gleichen Art dotiert sein wie die Schichten 15 und 16. In ähnlicher Weise erhält die Laserdiode einen Kontakt auf Schicht 12 oder 11.

Bei den Bausteinen nach Figur 1 und 2 sind beim zweiten Epitaxieschritt die beiden zusätzlichen Schichten 17 und 18 aufgebracht worden, wobei die Schicht 18 die für die Kontaktierung der Fotodiode 2 erforderliche Dotierung bereitstellt. Diese erforderliche Dotierung kann aber auch durch Diffusion in die undotierte Schicht 17 eingebracht werden. Die Figur 3 zeigt in der gleichen Darstellung wie die Figur 2 eine derartige Modifikation des Bausteins nach Figur 1. Bei dieser Modifikation sind das Substrat und die Schicht 11 $N^+$-dotiert und damit leitend. Die Schichten 12, 15 und 16 sind ebenfalls N-dotiert. Die Schicht 17 ist wieder undotiert, weist aber auf der vom Substrat 10 abgekehrten Seite einen $P^+$-dotierten Bereich 170 auf, der durch lokale Diffusion erzeugt worden ist. Dieser Bereich 170 ersetzt die bisherige Schicht 18. Mit 19 ist eine Deckschicht bezeichnet, die zugleich als Diffusionsmaske dient. Diese Schicht 19 wird nach dem selektiven Entfernen der Schicht 17 aufgebracht, und sie weist über der verbliebenen Schicht 17 eine Öffnung 119 auf, durch die das Diffusionsmaterial eingebracht werden kann und auf der danach der Kontakt für den $P^+$-dotierten Bereich 170 ausgebildet werden kann.

Bei dem Baustein nach Figur 3 sind die Schichten 12, 15 und 16 nicht wie bei den Bausteinen nach den Figuren 1 und 2 P-dotiert sondern N-dotiert. Daher muß der Bereich 170 P-dotiert sein. Diese Art der Dotierung hat auch zur Folge, daß im Bereich der Laserdiode 1 so tief dotiert, werden muß, beispielsweise durch Diffusion, daß dort die Schichten 14 und 15 vollständig vom P-Typ werden.

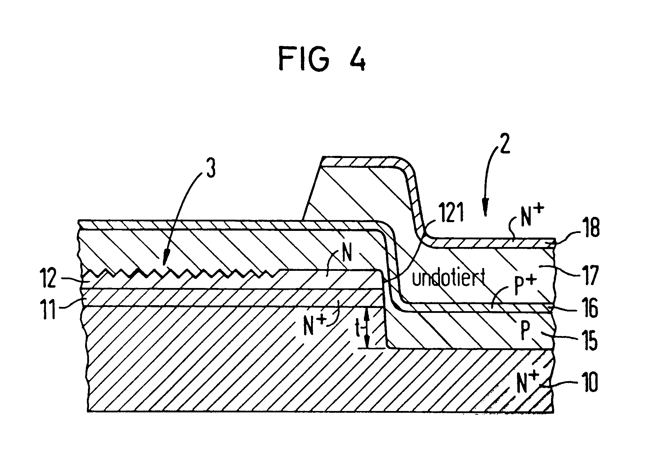

In der Figur 4 ist eine Ausführungsform des Bausteins nach Figur 1 in einer den Figuren 2 und 3 entsprechenden Darstellung gezeigt, bei der zwischen dem Streifen- oder Schichtwellenleiter 12 und dem Fotodetektor 2 eine Stirnflächenkopplung realisiert ist. Dazu ist rach dem ersten Epitaxieschritt und vor dem zweiten Epitaxieschritt neben dem Schritt der Strukturierung der Schicht 12 noch ein zusätzlicher Verfahrensschritt erforderlich, bei dem der beim ersten Epitaxieschritt aufgebrachte Schichtenstapel mit den Schichten 11 bis 14 und das Substrat bis zu einer bestimmten Tiefe lokal im Bereich des zu erzeugenden Fotodetektors 2 zu entfernen ist. Die Tiefe t, bis zu der das Substrat 10 lokal zu entfernen ist, ist so zu wählen, daß nach dem Aufbringen der Schichten 15, 16, 17 und ggf. 18 die Schicht 12 und die Schicht 17 im Bereich des Fotodetektors 2 auf gleicher Höhe liegen. Strahlung, die sich in der Schicht 12 vom Gitter 3 in Richtung des Fotodetektors 2 ausbreitet, tritt aus der bei dem zusätzlichen Verfahrensschritt entstandenen Stirnfläche 121 der Schicht 12 aus, durchstrahlt die dort im wesentlichen vertikal verlaufenden Schichten 15 und 16 und dringt dann in die auf gleicher Höhe liegende Schicht 17 ein. Ein Ablenkgitter ist bei diesem Baustein nicht mehr erforderlich.

Zum besseren Auskoppeln der Strahlung aus der laseraktiven Schicht 13 in den Streifen- oder Schichtwellenleiter 12 kann ein schräger Spiegel beitragen, der durch einen schrägen Verlauf der Stufe 52 in Figur 1, die bei allen anderen beschriebenen Modifikationen vorhanden ist, auf einfache Weise realisiert werden kann.

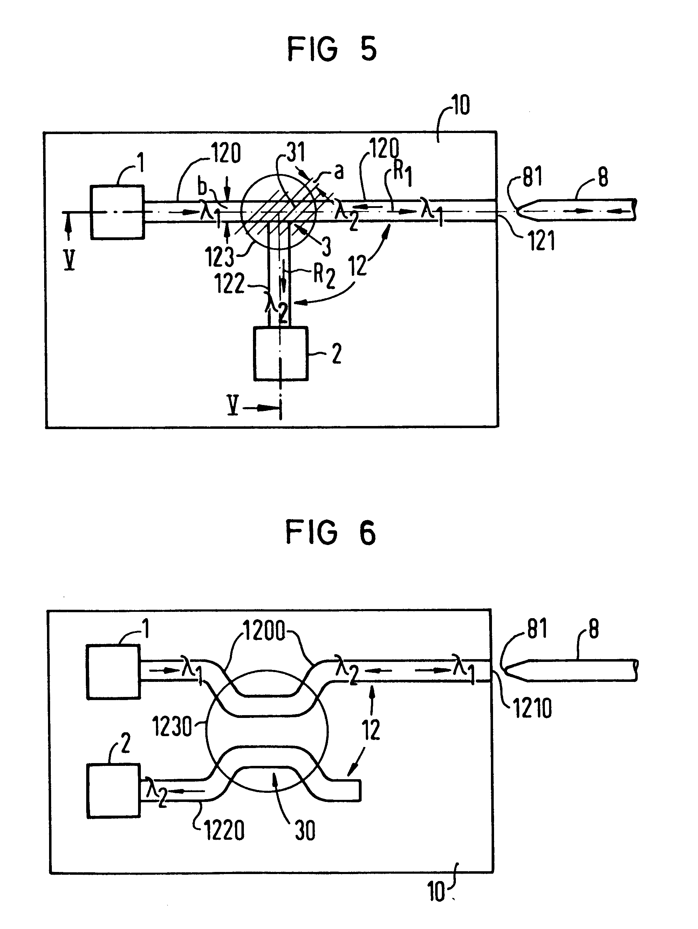

Bei dem in Figur 5 in Draufsicht dargestellten Multiplex-Demultiplex-Baustein sind die Laserdiode 1 und der Fotodetektor 2 schematisch durch Kästchen dargestellt. Der durch die Schicht 12 in den Figuren 1 bis 4 gebiliete strukturierte Streifenwellenleiter weist einen von der Laserdiode 1 beispielsweise geradlinig zu einem Rand des Substrats 10 führenden und dort endenden Streifenwellenleiterabschnitt 120 und einen von diesem abzweigenden und zum Fotodetektor 2 führenden Streifenwellenleiterabschnitt 122 auf. Dieser abzweigende Streifenwellenleiterabschnitt 122 grenzt unmittelbar an den einen Streifenwellenleiterabschnitt 120 an.

Im Bereich 123 der Abzweigung ist auf dem strukturierten Streifenwellenleiter 12 ein wellenlängenselektierendes Ablenkgitter 3 als Umlenkelement aufgebracht, das zumindest die Breite b des einen Streifenwellenleiterabschnitts 120 einnimmt. Die parallel zur Zeichenebene der Figur 5 verlaufenden und beispielsweise durch Furchen gebildeten Gitterstreifen 31 verlaufen schräg im Winkel sowohl zur Strahlungsausbreitungsrichtung $R_1$ der im einen Streifenwellenleiterabschnitt 120 als auch zur Strahlungsausbreitungsrichtung $R_2$ der im abzweigenden Streifenwellenleiterabschnitt 122 geführten Strahlung.

Der Schrägstellungswinkel der Gitterstreifen 31 und die Gitterkonstante a des Ablenkgitters 3 sind so bemessen, daß die von der Laserdiode 1 abgestrahlte Strahlung der einen Wellenlänge $\lambda_1$ in dem einen Streifenwellenleiterabschnitt 120 an dem abzweigenden Streifenwellenleiterabschnitt 122 vorbei zu dem einen Rand des Substrats 10 geführt wird, wo sie am Ende 121 des einen Streifenwellenleiterabschnitts 120 ausgekoppelt und beispielsweise in eine Glasfaser 8 durch deren dem Ende 121 gegenüberliegendes, beispielsweise taperförmiges Ende 81 eingekoppelt und fortgeleitet werden kann, und daß aus dieser Glasfaser 8 in den einen Streifenwellenletierabschnitt 120 eingekoppelte Strahlung der anderen Wellenlänge $\lambda_2$ in den abzweigenden Streifenwellenleiterabschnitt 122 eingekoppelt und zum Fotodetektor 2 geführt wird. Dabei gelangt weder ein wesentlicher Anteil der Strahlung der einen Wellenlänge $\lambda_1$ zum Fotodetektor noch ein wesentlicher Anteil der Strahlung mit der anderen Wellenlänge $\lambda_2$ zur Laserdiode 1.

Der in Figur 6 in Draufsicht dargestellte Multiplex-Demultiplex-Baustein unterscheidet sich von dem Baustein nach Figur 5 im wesentlichen nur dadurch, daß anstelle eines wellenlängenselektierenden Abzweiggitters 3 ein wellenlängenselektierender Richtkoppler 30 verwendet ist. Die Laserdiode und der Fotodetektor sind beim Baustein nach Figur 6 die gleichen wie beim Baustein nach Figur 5 und daher mit denselben Bezugszeichen 1 bzw. 2 versehen. Das gleiche gilt für die Glasfaser 8 mit dem taperförmigen Ende 81.

Dem Streifenwellenleiter 1200 mit dem Ende 1210 in Figur 6 entspricht der eine Streifenwellenleiterabschnitt 120 mit dem Ende 121 in Figur 5. Der andere Streifenwellenleiterabschnitt 1220 in Figur 6 entspricht dem abzweigenden Streifenwellenleiterabschnitt 122 in Figur 5.

Der abzweigende Streifenwellenleiterabschnitt 1220 ist im Bereich 1230 der Abzweigung über den zugleich das Umlenkelement bildenden wellenlängenselektierenden optischen Richtkoppler 30 an den einen Streifenwellenleiterabschnitt 1200 gekoppelt. Dazu verlaufen beispielsweise im Bereich 1230 der Abzweigung die beiden Streifenwellenleiterabschnitte 1200 und 1220 streckenweise in so geringem Abstand nebeneinander, daß zwischen ihnen die Strahlung der anderen Wellenlänge $\lambda_2$ überkoppeln kann, nicht dagegen die Strahlung der

Wellenlänge $\lambda_1$ aus der Laserdiode 1.

Die Streifenwellenleiterabschnitte 1200 und 1220 bilden zusammen mit dem Richtkoppler 30 den strukturierten Streifenwellenleiter, der wieder durch die Schicht 12 in den Figuren 1 bis 4 realisiert werden kann.

**Patentansprüche**

1. Verfahren zur Herstellung einer integriert-optischen Anordnung bestehend aus einer Laserdiode (1), einem Streifen- oder Schichtwellenleiter (15, 12, 11) und einem Photodetektor (2) auf einem gemeinsamen Substrat (10), wobei der Photodetektor (2) durch ein wellenlängenseletives Umlenkelement (3,4,30) an den Wellenleiter (15,12,11) gekoppelt ist, mit folgenden Schritten:
   - in einem ersten Epitaxieschritt wird ein Schichtenstapel (11-13) auf dem Substrat (10) erzeugt, der eine laseraktive Schicht (13) und eine darunterliegende, eine wellenleitende Schicht des Streifen- oder Schichtwellenleiters bildende tieferliegende Schicht (12) aufweist, deren Brechzahl größer als die der untersten schicht (11) und kleiner als die der laseraktiven Schicht (13) ist,
   - der Schichtenstapel wird außerhalb des für die Laserdiode (1) vorgesehenen Bereichs bis zur tieferliegenden Schicht (12) selektiv entfernt,
   - auf die so entstandene Oberfläche werden in einem zweiten Epitaxieschritt ganzflächig mindestens drei weitere Schichten (15 bis 17) aufgewachsen, von denen die der tieferliegenden Schicht (12) benachbarte Schicht (15) eine kleinere Brechzahl hat als die tieferliegende Schicht (12) und die oberste Schicht (17) der drei weiteren Schichten (15 bis 17) einen zu einer Dotierung der unmittelbar darunterliegenden Schicht (16) entgegengesetzt dotierten Bereich trägt oder enthält, und
   - das Umlenkelement (3,4,30) wird durch Strukturierung eines ausgewählten Bereichs des Schichtwellenleiters erzeugt.

2. Verfahren nach Anspruch 1, **dadurch gekennzeichnet,** daß der zur Dotierung der unmittelbar unter der obersten Schicht (17) der mindestens drei weiteren Schichten (15 bis 17) liegenden Schicht (16) entgegengesetzt dotierte Bereich durch Diffusion in die oberste Schicht (17) eingebracht wird, derart, daß sich der eindiffundierte Bereich nur über ein Teil der Schichtdicke dieser obersten Schicht (17) erstreckt.

3. Verfahren nach Anspruch 1, **dadurch gekennzeichnet,** daß der zur Dotierung der unmittelbar unter der obersten Schicht (17) der mindestens drei weiteren Schichten (15 bis 17) liegenden Schicht (16) entgegengesetzt dotierte Bereich durch zusätzliches Aufbringen einer diese entgegengesetzte Dotierung aufweisenden weiteren Schicht (18) auf diese oberste Schicht (17) beim zweiten Epitaxieschritt erzeugt wird.

4. Verfahren nach Anspruch 1, **dadurch gekennzeichnet,** daß vor dem zweiten Epitaxieschritt und nach dem selektiven Entfernen des beim ersten Epitaxieschritt erzeugten Schichtenstapels bis zur tieferliegenden Schicht (12) diese tieferliegende Schicht (12) zur Bildung eines passiven optischen Bauelements strukturiert wird.

5. Verfahren nach einem der vorhergehenden Ansprüche, **dadurch gekennzeichnet,** daß die oberste Schicht (17) der beim zweiten Epita-xieschritt aufgebrachten mindestens drei weite-ren Schichten (15 bis 17) außerhalb des für den Photodetektor (2) vorgesehenen Bereichs selektiv entfernt wird.

## Claims

1. Method for producing an integrated optical arrangement consisting of a laser diode (1), a strip- or layer-type waveguide (15, 12, 11) and a photodetector (2) on a common substrate (10), the photodetector (2) being coupled to the waveguide (15, 12, 11) by a wavelength-selective deflection element (3, 4, 30), comprising the following steps:
   - in a first epitaxial growth step, a stack of layers (11 - 13) is created on the substrate (10), which exhibits a laser-active layer (13), and an underlying lower layer (12) forming a wave-guiding layer of the strip- or layer-type waveguide, the refractive index of which is greater than that of the lowermost layer (11) and less than that of the laser-active layer (13),
   - the stack of layers is selectively removed down to the lower layer (12) outside the area provided for the laser diode (1),
   - on the surface produced in this manner, at least three further layers (15 to 17) are grown over the entire area in a second epitaxial growth step, of which layers the layer (15) adjacent to the lower layer (12) has a smaller refractive index than the lower layer (12) and the topmost layer (17) of the two further layers (15 to 17) carries or contains an area doped oppositely to a doping of the layer (16) immediately underneath, and the deflection element (3, 4, 30) is created by structuring a selected area of the layer-type waveguide.

2. Method according to Claim 1, characterised in that the area doped oppositely to the doping of the layer (16) located immediately underneath the topmost layer (17) of the at least three further layers (15 to 17) is introduced by diffusion into the topmost layer (17) in such a manner that the area diffused in only extends over a part of the layer thickness of this topmost layer (17).

3. Method according to Claim 1, characterised in that the area doped oppositely to the doping of the layer (16) located immediately below the topmost layer (17) of the at least three further layers (15 to 17) is created by additionally applying a further layer (18) exhibiting this opposite doping to this topmost layer (17) during the second epitaxial growth step.

4. Method according to Claim 1, characterised in that before the second epitaxial growth step and after the selective removal of the stack of layers created during the first epitaxial growth step down to the lower layer (12), this lower layer (12) is structured for forming a passive optical component.

5. Method according to one of the preceding claims, characterised in that the topmost layer (17) of the at least three further layers (15 to 17) applied during the second epitaxial growth step is selectively removed outside the area provided for the photodetector (2).

## Revendications

1. Procédé pour fabriquer un dispositif optique intégré, constitué par une diode laser (1), un guide d'ondes en forme de bande ou de couche (15,12,11) et un photodétecteur (2) disposés sur un substrat commun (10), et dans lequel le photodétecteur (2) est accouplé au guide d'ondes (15,12,11) par l'intermédiaire d'un élément de renvoi (3,4,30), qui est sélectif au point de vue des longueurs d'onde, comportant les étapes suivantes :
   - lors d'une première étape d'épitaxie, on forme sur le substrat (10) une pile de couches (11-13), qui possède une couche (13) active pour l'effet laser et une couche sous-jacente plus profonde (12), qui forme une couche de guidage des ondes du guide d'ondes en forme de bande ou de couche et dont l'indice de réfraction est supérieur à celui de la couche la plus basse (11) et inférieur à celui de la couche (13) active pour l'effet laser,

- on élimine de façon sélective la pile de couches en dehors de la zone prévue pour la diode laser (1), jusqu'à la couche (12) située plus bas,

- lors d'une seconde étape d'épitaxie, on fait croître sur l'ensemble de la couche ainsi obtenue, au moins trois autres couches (15 et 17), parmi lesquelles la couche (15) voisine de la couche plus basse (12) possède un indice de réfraction inférieur à celui de cette couche plus basse (12), et la couche la plus élevée (17) parmi les trois autres couches (15 à 17) porte ou comporte une zone possédant un dopage opposé à un dopage de la couche directement sous-jacente (16), et

- on forme l'élément de renvoi (3,4,30) grâce à une structuration d'une zone sélectionnée du guide d'ondes en forme de couche.

2. Procédé suivant la revendication 1, caractérisé par le fait qu'on insère par diffusion, dans la couche la plus élevée (17), la zone dopée avec un dopage opposé à celui de la couche (16) située directement au-dessous de la couche la plus haute (17) faisant partie des au moins trois autres couches (15 à 17), de manière que la zone formée par diffusion s'étende uniquement sur une partie de l'épaisseur de cette couche la plus élevée (17).

3. Procédé suivant la revendication 1, caractérisé par le fait qu'on forme, lors de la seconde étape d'épitaxie, la zone dopée avec un dopage opposé à celui de la couche (16) située directement au-dessous de la couche la plus haute (17) faisant partie des au moins trois autres couches (15 à 17), au moyen d'un dépôt supplémentaire d'une autre couche (18) possédant ce dopage opposé, sur cette couche la plus haute (17).

4. Procédé suivant la revendication 1, caractérisé par le fait qu'avant la seconde étape d'épitaxie et après l'élimination sélective de la pile de couches formée lors de la première étape d'épitaxie, jusqu'à la couche plus basse (12), on structure cette couche pour former un composant optique passif.

5. Procédé suivant l'une des revendications précédentes, caractérisé par le fait qu'on élimine de façon sélective la couche la plus haute (17) de l'ensemble formé d'au moins trois autres couches (15 à 17) déposées lors de la seconde étape d'épitaxie, à l'extérieur de la zone prévue pour le photodétecteur (2).

# FIG 1

# FIG 2

N+ 18
17
2
16
3 4 160 15
P+ P 12
11
N⁻
N⁻ 10

# FIG 3

2 170
P+
19
3 19 4 17
undotiert N 16
N 15
N N
12
11
N+
N+ 10

# FIG 4

EP 0 187 198 B1

## FIG 5

## FIG 6